# EUROPEAN PATENT SPECIFICATION

(11) **EP 4 495 657 B1**
(45) Date of publication and mention of the grant of the patent: **15.04.2026**
(21) Application number: 23186911.6
(22) Date of filing: 21.07.2023
(51) Int. Cl.: G02B 21/00, G01N 21/64

(54) **DETECTOR DEVICE**
DETEKTORVORRICHTUNG
DISPOSITIF DE DÉTECTION

(43) Date of publication of application: 22.01.2025
(73) Proprietor: Leica Microsystems CMS GmbH, 35578 Wetzlar (DE)
(72) Inventor: Alvarez, Luis, 35578 Wetzlar (DE); Ossato, Giulia, 35578 Wetzlar (DE); Schwarz, Ulf, 35578 Wetzlar (DE); Eich, Florian, 35578 Wetzlar (DE)
(74) Representative: Schaumburg und Partner Patentanwälte mbB

(56) References cited:
- WO-A1-2020/207571
- WO-A1-2022/022807
- US-A1- 2015 362 715
- US-A1- 2021 278 650
- CASTELLO MARCO ET AL: "A robust and versatile platform for image scanning microscopy enabling super-resolution FLIM", NATURE METHODS, NATURE PUBLISHING GROUP US, NEW YORK, vol. 16, no. 2, 14 January 2019 (2019-01-14), pages 175 - 178, XP036694959, ISSN: 1548-7091, [retrieved on 20190114], DOI: 10.1038/S41592-018-0291-9

## Description

### Technical field

The invention relates to a detector device.

### Background

Multi-element detectors such as single-photon avalanche diode (SPAD) arrays, gallium arsenide phosphide (GaAsP) photomultiplier tube (PMT) arrays, scientific cameras, gated cameras, etc. have become popular as fluorescence detectors in microscopy, especially due to their ability to perform image scanning microscopy (ISM), which enhances the lateral resolution of the acquired data.

ISM is capable of significantly improving the spatial resolution of a confocal microscope. In conventional confocal microscopy, a point detector such a single photomultiplier tube is used to detect the fluorescence light emerging from the sample. According to the ISM approach, the point detector is replaced by a multi-element photodetector comprising plurality of photodetector elements (pixels) arranged in a photodetector array, wherein each photodetector element is configured to output a detector signal upon receiving fluorescence light. While scanning the sample with a laser focus, each photodetector element detects at each scan position a small image of the illuminated sample. By applying suitable algorithms, multiple scan images are then combined to reconstruct a single high-resolution image of the sample.

While it is possible to use the information from the different photodetector elements to increase the spatial image resolution, one of the main limits of current ISM implementations is the restricted usability of these photodetectors for quantifying fluorescence in terms of both intensity and (fluorescence) lifetime due to their long dead time. The latter is the time after each photon detection event during which the detector is not able to record another event. Conventional ISM detectors currently exhibit dead times in the range of tens of nanoseconds which limits the dynamic range of the detectors in the photon counting mode. Such a dead time is 10 to 15 times longer than the dead time of a hybrid detector typically used for lifetime measurements. Moreover, the overall photon flux during image acquisition may also suffer since long dead times of the photodetectors prevent the latter from being active to detect a sufficiently large fraction of the available photons.

To acquire robust fluorescence lifetime imaging microscopy (FLIM) data at video rate speeds without encountering pile-up artifacts, it is crucial to minimize the overall dead time in photon counting. However, employing ISM capable detectors for FLIM would require reducing the acquisition speed to a level consistent with standards prior to already enhanced solution such as an approach known as FAst Lifetime CONtrast (FALCON) described in the article of Alvarez, L. A. J. et al., Application Note: SP8 FALCON: a novel concept in fluorescence lifetime imaging enabling video-rate confocal FLIM, Nat. Methods https://www.nature.com/articles/d42473-019-00261-x (2019). This affects the applicability of array detectors for acquiring FLIM data to study fast dynamic biological processes.

A technique known as Airyscan that is based on confocal laser scanning microscopy is disclosed in WO 2013/135487 A1. This technique uses a multi-element photodetector capturing the light from the sample. With regard to a point emitter that is imaged, the lateral point spread function (PSF) is scanned.

For prior art, further reference is made to the articles of Bruschini, C. et al., Single-photon avalanche diode imagers in biophotonics: review and outlook, Light Sci. Appl. 8, 87 (2019), https://doi.org/10.1038/s41377-019-0191-5; and Slenders E. et al., Cooled SPAD array detector for low light-dose fluorescence laser scanning microscopy, Biophys. Rep. (N Y). 2021 Dec 8;1(2), doi: 10.1016/j.bpr.2021.100025. These articles address the problem of dead time for certain detectors.

WO 2020/207571 A1 discloses a sensor array for a light microscope, which comprises a plurality of photon-counting detector elements. The detector elements may be grouped into superpixels.

Further reference is made to US 2021/278650 A1, WO 2022/022807 A1, US 2015/362715 A1, and to Castello Marco et al: "A robust and versatile platform for image scanning microscopy enabling super-resolution FLIM", Nature Methods, Nature Publishing Group US, New York, vol. 16, no. 2, 14 January 2019 (2019-01-14), pages 175-178, XP036694959, ISSN: 1548-7091, DOI: 10.1038/S41592-018-0291-9.

### Summary

It is an object to provide a detector device which is capable of both high-resolution imaging and fast lifetime measurements.

The afore-mentioned object is achieved by the detector device according to claim 1. Advantageous embodiments are defined in the dependent claims and the following description.

The detector device comprises a multi-element photodetector having a plurality of photodetector elements arranged in a photodetector array, wherein each photodetector element is configured to output a detector signal upon receiving light. The plurality of photodetector elements is arranged in more than one photodetector group. Each photodetector group may have a signal combiner configured to combine the detector signals of the photodetector elements into a collective output signal of the photodetector group to reduce a dead time thereof. The photodetector groups differ from each other with respect to a density at which the photodetector elements are arranged in the respective photodetector group.

The proposed detector device allows to acquire images with high spatial resolution and, in addition, to perform lifetime measurements such as FLIM without the need to slow down the lifetime measurements due to dead time constraints. It is to be noted that slowing down a lifetime measurement by a certain factor (such as a factor of 10 to 15 which is typical in conventional systems) is accompanied by a reduction of the number of photons detected per time unit (acquisition speed) by the same factor. Thus, it is evident how important it is to avoid such a slowdown.

The detector device can be used to provide two distinct operating modes. Thus, there is a first operating mode (hereinafter "high-resolution mode") where the detector device is used for high-resolution applications such as ISM, and a second operating mode (hereinafter "low-dead time mode") where the detector device is used for fast photon counting or lifetime measurements such as FLIM.

Each photodetector element may be configured to individually output the respective detector signal. This enables the multi-element photon detector to be operated in the high-resolution mode where each photodetector element contributes to recording the lateral spread of the light across the photodetector array. When operated in the low-dead time mode, the multi-element photodetector uses a signal combiner assigned to a photodetector group to combine the detector signals of the photodetector elements of the photodetector group into a collective output signal of the photodetector group. For example, if a certain photodetector element of the photodetector group detects a photon and is therefore unable to detect a subsequent photon during its individual dead time, another photodetector element of the photodetector group is available to capture the subsequent photon. It might be possible that the optical distributor is operated such that only a part of the light is detected and that a remaining part of the light is not detected by the detector device or such that the photon flux at each photodetector element stays below the dead time limitation. As a result, the dead time of the photodetector group as a whole is decreased compared to the individual dead times of the photodetector elements included in the group.

In the high-resolution mode, when an optical system being configured to image or focus the light to be detected is properly aligned and the light is focused onto the multi-element photodetector, a central part of the light may fall onto the photodetector elements located in the center of the detector array, while the peripheral detector elements detect the lateral spread of light that results from diffraction of the light to be detected. Detecting and analyzing the lateral light spread across the photodetector array allows to understand the contributions of the peripheral parts of an Airy disk as well as the contributions of noise, which in turn allows a better understanding of the PSF (point spread function). This knowledge can be used e.g. to train a deconvolution algorithm for reconstructing an image with a high resolution beyond the diffraction limit.

To reduce the dead time by combining the photodetector elements to a distinct photodetector group, the light beam can be distributed laterally across the photodetector group in a homogeneous manner such that a photon has approximately an equal probability of being detected by each of the photodetector elements forming the photodetector group. This can be done in particular by combining suitable photodetector elements to a distinct photodetector group in dependence of a spatial intensity distribution or a spatial distribution characteristic of the light beam to be detected.

The density at which the photodetector elements are arranged in the respective photodetector group may vary depending on an intensity distribution of the light across the photodetector group.

The optical distributor may comprise, for example, a defocus lens, a digital micromirror device (DMD), or an electrically tunable lens.

Preferably, at least a first photodetector group and a second photodetector group may be provided, wherein the density of the photodetector elements included in the first photodetector group is higher than the density of the photodetector elements included in the second photodetector group. Thus, the photodetector element density is adapted to the light intensity distribution incident onto the multi-element photodetector.

The intensity of the light across the first photodetector group may be higher than the intensity of the light across the second photodetector group.

Preferably, the first photodetector group is disposed in a central portion of the photodetector array, and the second photodetector group is disposed in an outer portion of the photodetector array surrounding the central portion or adjacent to the central portion. In that case, the first photodetector group is adapted to essentially capture the maximum of the light distribution which is typically on the optical axis of the optical detection system.

In a preferred embodiment, the photodetector groups or the photodetector array are arranged on a planar surface. To ensure a flat detector design, the multi-element photodetector may comprise an optical device configured to flatten a wavefront of the light.

According to another embodiment, the photodetector groups or the photodetector array are arranged on a curved surface. In this embodiment, a central photodetector group may be arranged to detect a central Airy node of the intensity distribution that is incident on the multi-element photodetector. The remaining intensity may then be spread into the outer photodetector groups or adjacent photodetector groups.

In a further embodiment, the photodetector groups are arranged to detect different spectral components of the light. Here, the multi-element photodetector include a plurality of photodetector elements which may be identical in size and shape but have different spectral characteristics. Multiple adjacent photodetector elements may be combined to form a photodetector group in order to reduce overall the dead time.

The optical distributor may be configured to distribute the light such that a variation in the intensity distribution of the light across the photodetector group is below a predetermined tolerance threshold. This ensures that a photon has approximately the same probability of being detected by each of the photodetector elements which are arranged to form the photodetector group.

In a preferred embodiment, the optical distributor is configured to be switched between a first mode in which the light is distributed across the photodetector group and a second mode in which the light is not distributed across the photodetector group. By switching the optical distributor between the first mode, which is the high-resolution mode mentioned above, and the second mode, which is the low-dead time mode mentioned above, a user can selectively change between, for example, an ISM measurement and a FLIM measurement.

According to another aspect, a method for detecting light using the detector device described above is provided.

In the presence of one photodetector group, the light may be irradiated onto the photodetector group alternately in a distributed manner to generate low-dead time data and in a non-distributed manner to generate high-resolution data.

Preferably, the high-resolution data is used as training data to refine the low-dead time data. Being able to alternate between the high-resolution mode and the low-dead time mode can be paired with an artificial intelligence (AI) or machine learning (ML) so that, for example, ISM data can be used as training data. Thus, it is possible to acquire data with short dead times that can then be treated to show the equivalent ISM like image.

### Short Description of the Figures

Hereinafter, specific embodiments are described referring to the drawings, wherein:
- Figure 1: a block diagram showing a detector device including a multi-element photodetector according to an embodiment;
- Figure 2: a schematic diagram illustrating a light intensity distribution across amulti-element photodetector in the high-resolution mode;
- Figure 3: a schematic diagram illustrating a light intensity distribution across amulti-element photodetector in the low-dead time mode;
- Figure 4: a schematic diagram illustrating the light intensity distribution across a multi-element photodetector according to another embodiment;
- Figure 5: a schematic diagram showing a curved multi-element photodetector according to another embodiment;
- Figure 6: a schematic diagram showing a flat multi-element photodetector according to another embodiment; and
- Figure 7: a schematic diagram showing a spectral multi-element photodetector

### Detailed Description

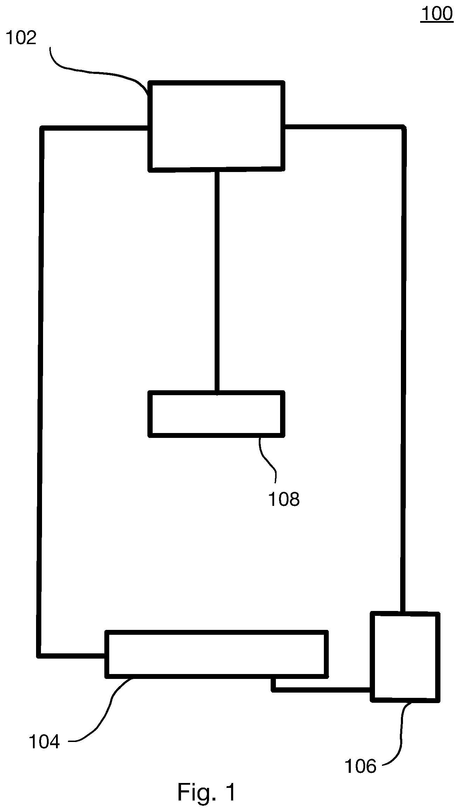

Figure 1 is a block diagram showing a detector device 100 according to an embodiment which may be used in a microscope to enable both a high-resolution mode in which high-resolution imaging such ISM is performed and a low-dead time mode in which fast photon counting or lifetime measurement such as FLIM is performed.

The detector device 100 may comprise a controller 102 which is configured to control the individual components of the detector device 100. The detector device 100 includes a multi-element photodetector 104 having a plurality of photodetector elements. The multi-element photodetector 104 may be configured as a system-on-chip, i.e. an integrated circuit that integrates the components of the multi-element photodetector 104. The detector device 100 may further include a signal combiner 106 which is capable of combining detector signals output from the photodetector elements as well as an optical distributor 108 that is configured to distribute detection light from a sample across the multi-element photodetector 104 as explained below in more detail.

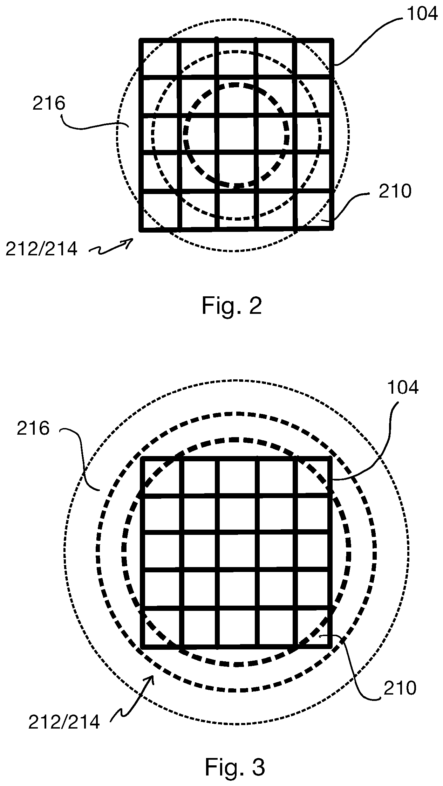

Figure 2 and 3 illustrate an intensity distribution of the detection light distribution which is formed on the multi-element photodetector 104 in the high-resolution mode and the low-dead time mode, respectively.

As shown in Figures 2 and 3, the multi-element photodetector 104 includes a plurality of photodetector elements 210 forming a photodetector array 212. Each photodetector element 210 is configured to output a detector signal when detection light is incident onto the photodetector element 210. According to the example shown in Figures 2 and 3, which does not fall under the scope of claim 1, the photodetector elements 104 are identical in size and shape so that the photodetector array 212 forms a regular pattern. Thus, a density at which the photodetector elements 210 are arranged on the multi-element photodetector 104 is constant across the photodetector array 212.

In the example of Figures 2 and 3, the controller 102 of the detector device 100 (see Figure 1) may be configured to switch between the high-resolution mode and the low-dead time mode by controlling the multi-element photodetector 104, the signal combiner 106 and the optical distributor 108 accordingly.

In the high-resolution mode, the controller 102 causes each of the plurality of photodetector elements 210 to output its detector signal individually. This allows an intensity distribution 216 of the detection light to be detected by the multi-element photodetector 104 in a spatially resolved manner. In Figure 2, the intensity distribution 216 is illustrated by dashed circles, different line widths thereof indicating that the intensity distribution 216 decreases from the center toward the edge of the multi-element photodetector 104. Thus, the photon density of the detection light is maximum in the center of the multi-element photodetector 104 and decreases radially outward. In the high-resolution mode, this radially decreasing photon density can be detected spatially resolved by the individual photodetector elements 210.

In the low-dead time mode, the controller 102 may selectively cause the signal combiner 106 to combine the detector signals of the individual photodetector elements 210 into a collective output signal to reduce the overall dead time of the multi-element photodetector 104. According to the present embodiment, the plurality of photodetector elements 210 collectively forms a single photodetector group 214 whose individual detector signals can be combined by means of the signal combiner 106.

To enable a reduction in dead time by interconnecting the photodetector elements 210 to form the collectively analyzable photodetector group 214, the optical distributor 108 distributes the detection light laterally across the photodetector group 214 in a homogeneous manner as illustrated in Figure 3. This ensures that a photon in the central portion of the detected light beam has approximately the same probability of being detected by each of the photodetector elements 210 forming the photodetector group 214. In the example shown in Figure 3, it is assumed that the central part of the intensity distribution 216 (represented by the radially inner circle) is essentially homogeneous in lateral direction.

For creating the laterally homogeneous intensity distribution 216 shown in Figure 3, the optical distributor 108 (see Figure 1) may be formed from an optical element that is, for example, selectively introduced into the detection beam path in the low-dead time mode. Such an optical element may be a defocus lens which is adapted to defocus the detection light for distributing the photon flux across the entire photodetector group 214. However, portions of the incident light beam might not be detected by the photodetector group 214 or the detector device, because that portions do not interact with any photodetector elements. The optical distributor 108 may be configured to distribute the light such that a variation in the intensity distribution 216 of the light across the photodetector group 214 is below a tolerance threshold. Thus, it is ensured that the photon density on the photodetector group 214 is approximately constant.

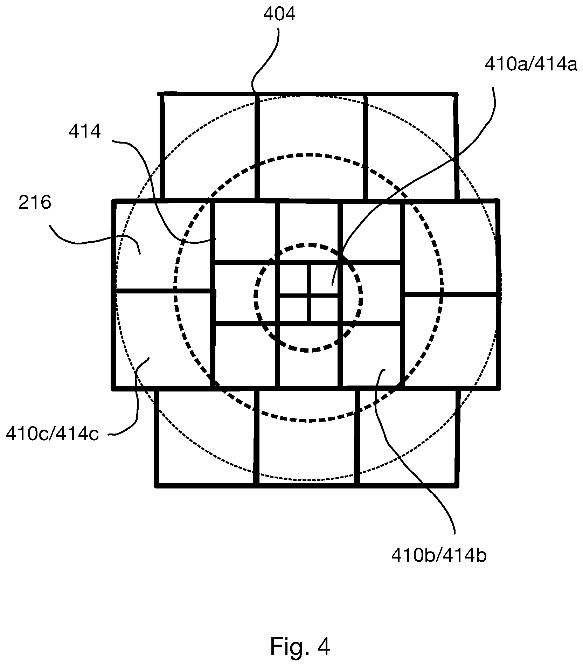

Figure 4 shows an embodiment in which the detector device 100 includes a modified multi-element photodetector 404.

In contrast to the multi-element photodetector 104 shown in Figures 2 and 3 where the photodetector elements 210 are identical in size and shape, the modified multi-element photodetector 404 comprises multiple types of photodetector elements of different sizes. The smallest photodetector elements 410a may be located in a central portion of the multi-element photodetector 404, while the other photodetector elements 410b, 410c are located in progressively outward portions as they increase in size. Figure 4 shows an example with three types of photodetector elements 410a, 410b and 410c, wherein the photodetector elements 410a are arranged in a radially inner portion of the multi-element photodetector 404, the photodetector element 410b are arranged in a radially middle portion surrounding the radially inner portion of the multi-element photodetector 404, and the photodetector element 410c are arranged in a radially outer portion surrounding the radially inner portion and the radially middle portion of the multi-element photodetector 404.

While in the examples shown Figures 2 and 3, the photodetector elements 210 are combined to form one single photodetector group that is used to generate the collective output signal for dead time reduction, in the embodiment of Figure 4, the photodetector elements 410a, 410b, and 410c are arranged to form three photodetector groups 414a, 414b, and 414c. Due to the different sizes of the photodetector elements 410a, 410b, 410c, the corresponding groups 414a, 414b, 414c differ from each other with respect to a density at which the photodetector elements 410a, 410b, 410c are arranged in the respective photodetector group. The density varies depending on the expected light intensity distribution 216 across the respective photodetector group.

As can be seen in Figure 4, the photodetector group 414a is located in a region where the intensity distribution 216 has its maximum. Therefore, the photodetector group 414a includes the photodetector elements 410a which are smaller than the other photodetector elements 410b, 410c. Accordingly, the photodetector group 414a has a higher photodetector element density that the surrounding photodetector groups 414b, 414c. In other words, as the intensity distribution 216 decreases radially outward, the density of the photodetector elements of the different photodetector groups also decreases from the center to the edge of the multi-element photodetector 404.

Dividing the multi-element photodetector 404 into multiple photodetector groups 414a, 414b, 414c in accordance with the intensity distribution 216 ensures that all of the photodetector elements 410a, 410b, 410c of the corresponding photodetector group 414a, 414b, 414c have an approximately equal probability of detecting a photon. According to this embodiment, each photodetector group 414a, 414b, 414c may be provided with a signal combiner as explained above. In the low-dead time mode, the controller 102 causes the signal combiner that is associated with the respective photodetector group 414a, 414b, 414c to combine the detector signals of the individual photodetector elements 410a, 410b, 410c of this photodetector group 414a, 414b, 414c into a collective output signal. Thus, interconnecting the photodetector elements 410a, 410b, 410c to form the collectively analyzable photodetector groups 414a, 414b, 414c, respectively, enables a reduction in the overall dead time.

On the other hand, in the high-resolution mode, the controller 102 causes each of the plurality of photodetector elements 410a, 410b, 410c to output its detector signal individually. Thus, the intensity distribution 216 of the detection light can be detected by the multi-element photodetector 104 in a spatially resolved manner.

As can be seen from the above, the embodiment shown in Figure 4, unlike the configuration of Figures 2 and 3, does not require an optical distributor such as a defocus lens to switch between the high-resolution mode and the low-dead time mode.

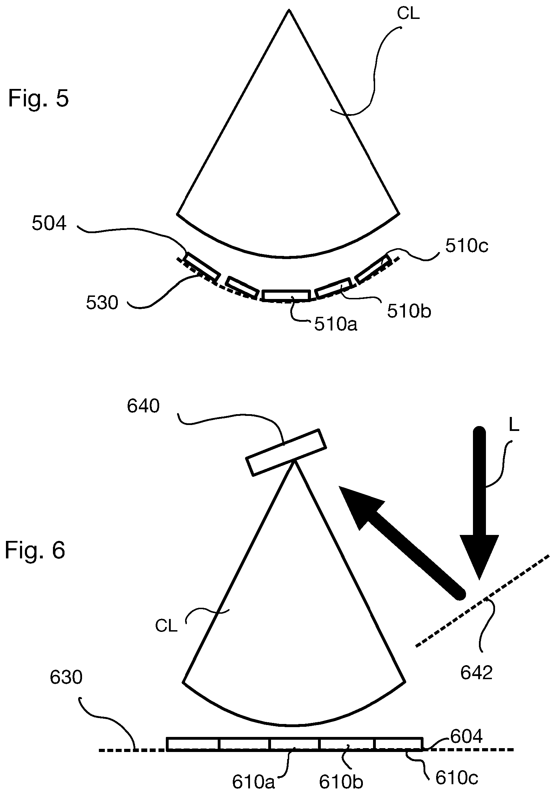

Figure 5 shows another embodiment having a modified multi-element photodetector 504 with a plurality of photodetector elements which are arranged on a curved surface 530. Thus, the photodetector elements of the multi-element photodetector 504 are arranged in a three-dimensional (3D) shape. In this configuration, the central photodetector elements (referred to as 510a in Figure 5) are arranged to detect a central Airy node of the intensity distribution that is incident on the multi-element photodetector 504. The remaining intensity is spread into the outer photodetector elements (referred to as 510b and 510c in Figure 5). Thus, the multi-element photodetector 540 shown in Figure 5 is shaped in a 3D pattern in which the radially outer photodetector elements 510b, 510c are raised progressively in a curved manner to form a bucket-like structure. Apart from the 3D structure, the multi-element photodetector 504 operates in essentially the same way as the embodiment shown in Figure 4 for switching between the high-resolution mode and the low-dead time mode.

Figure 6 shows a modification of the configuration of Figure 5. In this embodiment, a multi-element photodetector 604 includes a DMD 640 which directs the detection light L reflected at a mirror 642 onto photodetector elements 610a, 610b, 610c. The DMD 640 is configured to flatten a wavefront of the light incident onto the photodetector elements 610a, 610b, 610c. As a result, the photodetector elements 610a, 610b, 610c may be arranged on a flat surface 630 rather on a curved surface. Thus, while maintaining the same functionality as the configuration of Figure 5, a flat detector design can be used. The circular sector CL shown in Fig. 5 and 6 represents a cross section of a diverging light beam to be detected, wherein the curved part of the circular sector CL represents a wavefront of the light beam.

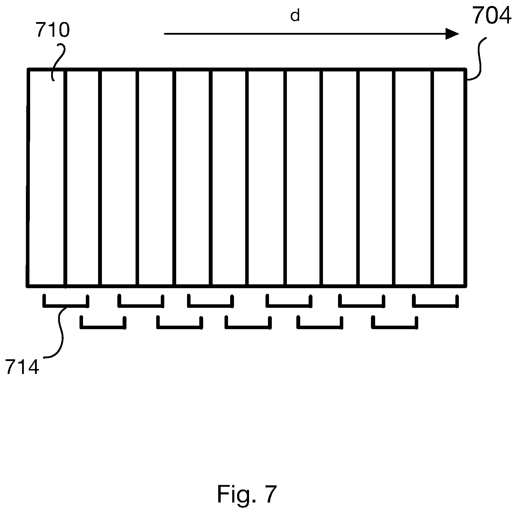

Figure 7 shows another example not being part of the claimed invention including a multi-element photodetector 704 that is used as a spectral detector and may be arranged next to each other along a respective direction d. The multi-element photodetector 704 includes a plurality of photodetector elements 710 which may be identical in size and shape. Two directly adjacent photodetector elements 710 are combined (paired) to form a photodetector group in the low-dead time mode. As result, multiple photodetector groups 714 are created as illustrated by square brackets in Figure 7. Using an optical distributor as explained above, the light may be spread across the multi-element photodetector 704 such each photodetector group 714 can be used to quantify the photon flux of a specific spectral component over time. Using a spectrally dispersing element in the beam path upstream the detector device, e.g. a prism or a grating (not shown), for spectrally distributing and imaging or focusing the light to be detected on the photodetector elements 710 allows single photodetector elements 710 to detect a particular spectral portion of the light to be detected.

As used herein the term "and/or" includes any and all combinations of one or more of the associated listed items and may be abbreviated as "/".

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

### List of Reference Signs

- 100: detector device
- 102: controller
- 104: multi-element photodetector
- 106: signal combiner
- 108: optical distributor
- 210: photodetector element
- 212: photodetector array
- 214: photodetector group
- 216: intensity distribution
- 404: multi-element photodetector
- 410a,b,c: photodetector element
- 412: photodetector array
- 414a,b,c: photodetector group
- 504: multi-element photodetector
- 510a,b,c: photodetector element
- 530: curved surface
- 604: multi-element photodetector
- 610a,b,c: photodetector element
- 630: plane surface
- 640: DMD
- 642: mirror
- 704: multi-element photodetector
- 710: photodetector element
- 714: photodetector group
- L: light

## Claims

1. A detector device (100) for a microscope, comprising:
a multi-element photodetector (104, 404) having a plurality of photodetector elements (210, 410a, 410b, 410c) arranged in a photodetector array (212, 412), each photodetector element (210, 410a, 410b, 410c) configured to output a detector signal upon receiving light,
wherein the plurality of photodetector elements (210, 410a, 410b, 410c) is arranged in more than one photodetector group (214, 414a, 414b, 414c), each photodetector group (214, 414a, 414b, 414c) having a signal combiner (106) configured to combine the detector signals of the photodetector elements (210, 410a, 410b, 410c) into a collective output signal of the photodetector group (214, 414a, 414b, 414c) to reduce a dead time thereof, **characterized in that**
the photodetector groups (214, 414a, 414b, 414c) differ from each other with respect to a density at which the photodetector elements (410a, 410b, 410c) are arranged in the respective photodetector group.

2. The detector device (100) according to claim 1, wherein the density at which the photodetector elements (410a, 410b, 410c) are arranged in the respective photodetector group (414a, 414b, 414c) varies depending on an intensity distribution of the light across the photodetector group (414a, 414b, 414c).

3. The detector device (100) according to claim 1 or 2, wherein the photodetector groups comprise at least a first photodetector group (414a) and a second photodetector group (414b, 414c), the density of the photodetector elements (410a) included in the first photodetector group (414a) being higher than the density of the photodetector elements (410b, 410c) included in the second photodetector group (414b, 414c).

4. The detector device (100) according to claim 3, wherein the intensity of the light across the first photodetector group (414a) is higher than the intensity of the light across the second photodetector group (414a, 414b).

5. The detector device (100) according to claim 3 or 4, wherein the first photodetector group (414a) is disposed in a central portion of the photodetector array and the second photodetector group (414b, 414c) is disposed in an outer portion of the photodetector array surrounding the central portion or adjacent to the central portion.

6. The detector device (100) according to any one of the preceding claims, wherein the photodetector elements (210, 410a, 410b, 410c, 610a, 610b, 610c) are arranged on a planar surface (630).

7. The detector device (100) according to any one of the preceding claims, comprising an optical device (640) configured to flatten a wavefront of the light.

8. The detector device (100) according to any one of the claims 1 to 5, wherein the photodetector elements (510a, 510b, 510c) are arranged on a curved surface (530).

9. The detector device (100) according to any one of the preceding claims, wherein the photodetector groups (714) are arranged to detect different spectral components of the light.

10. The detector device (100) according to any one of the preceding claims, wherein the optical distributor (108) is configured to distribute the light such that a variation in the intensity distribution of the light across the photodetector group (214, 414a, 414b, 414c) is below a predetermined tolerance threshold.

11. The detector device (100) according to claim 10, wherein the optical distributor (108) is configured to be switched between a first mode in which the light is distributed across the photodetector group (214, 414a, 414b, 414c) and a second mode in which the light is not distributed across the photodetector group (214, 414a, 414b, 414c).

12. The detector device (100) according to any one of the preceding claims, wherein each photodetector element is configured to individually output the respective detector signal.

13. A method for detecting light using the detector device (100) according to one of the preceding claims.

## Patentansprüche

1. Detektorvorrichtung (100) für ein Mikroskop, umfassend:
einen Photodetektor (104, 404) mit mehreren Elementen, der eine Mehrzahl von Photodetektorelementen (210, 410a, 410b, 410c) aufweist, die in einem Photodetektorarray (212, 412) angeordnet sind, wobei jedes Photodetektorelement (210, 410a, 410b, 410c) zum Ausgeben eines Detektorsignals beim Empfangen von Licht ausgebildet ist,
wobei die Mehrzahl von Photodetektorelementen (210, 410a, 410b, 410c) in mehr als einer Photodetektorgruppe (214, 414a, 414b, 414c) angeordnet ist, wobei jede Photodetektorgruppe (214, 414a, 414b, 414c) einen Signalkombinierer (106) aufweist, der dazu ausgebildet ist, die Detektorsignale der Photodetektorelemente (210, 410a, 410b, 410c) zu einem kollektiven Ausgabesignal der Photodetektorgruppe (214, 414a, 414b, 414c) zu kombinieren, um eine Totzeit davon zu reduzieren,
**dadurch gekennzeichnet, dass**
die Photodetektorgruppen (214, 414a, 414b, 414c) sich voneinander in Bezug auf eine Dichte unterscheiden, mit der die Photodetektorelemente (410a, 410b, 410c) in der jeweiligen Photodetektorgruppe angeordnet sind.

2. Detektorvorrichtung (100) nach Anspruch 1, wobei die Dichte, mit der die Photodetektorelemente (410a, 410b, 410c) in der jeweiligen Photodetektorgruppe (414a, 414b, 414c) angeordnet sind, abhängig von einer Intensitätsverteilung des Lichts über die Photodetektorgruppe (414a, 414b, 414c) variiert.

3. Detektorvorrichtung (100) nach Anspruch 1 oder 2, wobei die Photodetektorgruppen zumindest eine erste Photodetektorgruppe (414a) und eine zweite Photodetektorgruppe (414b, 414c) umfassen, wobei die Dichte der Photodetektorelemente (410a), die in der ersten Photodetektorgruppe (414a) eingeschlossen sind, höher ist als die Dichte der Photodetektorelemente (410b, 410c), die in der zweiten Photodetektorgruppe (414b, 414c) eingeschlossen sind.

4. Detektorvorrichtung (100) nach Anspruch 3, wobei die Intensität des Lichts über die erste Photodetektorgruppe (414a) höher ist als die Intensität des Lichts über die zweite Photodetektorgruppe (414a, 414b).

5. Detektorvorrichtung (100) nach Anspruch 3 oder 4, wobei die erste Photodetektorgruppe (414a) in einem zentralen Abschnitt des Photodetektorarrays angeordnet ist und die zweite Photodetektorgruppe (414b, 414c) in einem äußeren Abschnitt des Photodetektorarrays angeordnet ist, der den zentralen Abschnitt umgibt oder zu dem zentralen Abschnitt benachbart ist.

6. Detektorvorrichtung (100) nach einem der vorstehenden Ansprüche, wobei die Photodetektorelemente (210, 410a, 410b, 410c, 610a, 610b, 610c) auf einer ebenen Fläche (630) angeordnet sind.

7. Detektorvorrichtung (100) nach einem der vorstehenden Ansprüche, umfassend eine optische Vorrichtung (640), die zum Glätten einer Wellenfront des Lichts ausgebildet ist.

8. Detektorvorrichtung (100) nach einem der Ansprüche 1 bis 5, wobei die Photodetektorelemente (510a, 510b, 510c) auf einer gekrümmten Fläche (530) angeordnet sind.

9. Detektorvorrichtung (100) nach einem der vorstehenden Ansprüche, wobei die Photodetektorgruppen (714) so angeordnet sind, dass sie unterschiedliche Spektralkomponenten des Lichts detektieren.

10. Detektorvorrichtung (100) nach einem der vorstehenden Ansprüche, wobei der optische Verteiler (108) dazu ausgebildet ist, das Licht so zu verteilen, dass eine Variation in der Intensitätsverteilung des Lichts über die Photodetektorgruppe (214, 414a, 414b, 414c) unter einem vorbestimmten Toleranzschwellenwert liegt.

11. Detektorvorrichtung (100) nach Anspruch 10, wobei der optische Verteiler (108) dazu ausgebildet ist, zwischen einem ersten Modus, in dem das Licht über die Photodetektorgruppe (214, 414a, 414b, 414c) verteilt wird, und einem zweiten Modus, in dem das Licht nicht über die Photodetektorgruppe (214, 414a, 414b, 414c) verteilt wird, geschaltet zu werden.

12. Detektorvorrichtung (100) nach einem der vorstehenden Ansprüche, wobei jedes Photodetektorelement dazu ausgebildet ist, individuell das jeweilige Detektorsignal auszugeben.

13. Verfahren zum Detektieren von Licht unter Verwendung der Detektorvorrichtung (100) nach einem der vorstehenden Ansprüche.

## Revendications

1. Dispositif de détection (100) pour microscope, comprenant :
un photodétecteur (104, 404) multi-éléments présentant une pluralité d'éléments photodétecteurs (210, 410a, 410b, 410c) agencés dans une matrice (212, 412) de photodétecteurs, chaque élément photodétecteur (210, 410a, 410b, 410c) étant configuré pour émettre un signal de détecteur lors de la réception de lumière,
dans lequel la pluralité d'éléments photodétecteurs (210, 410a, 410b, 410c) est agencée dans plus d'un groupe photodétecteur (214, 414a, 414b, 414c), chaque groupe photodétecteur (214, 414a, 414b, 414c) présentant un combineur (106) de signaux configuré pour combiner les signaux de détecteur des éléments photodétecteurs (210, 410a, 410b, 410c) en un signal de sortie collectif du groupe photodétecteur (214, 414a, 414b, 414c) pour réduire un temps mort de celui-ci,
**caractérisé en ce que**
les groupes photodétecteurs (214, 414a, 414b, 414c) diffèrent les uns des autres en ce qui concerne une densité à laquelle les éléments photodétecteurs (410a, 410b, 410c) sont agencés dans le groupe photodétecteur respectif.

2. Dispositif de détection (100) selon la revendication 1, dans lequel la densité à laquelle les éléments photodétecteurs (410a, 410b, 410c) sont agencés dans le groupe photodétecteur (414a, 414b, 414c) respectif varie en fonction d'une distribution d'intensité de la lumière à travers le groupe photodétecteur (414a, 414b, 414c).

3. Dispositif de détection (100) selon la revendication 1 ou la revendication 2, dans lequel les groupes photodétecteurs comprennent au moins un premier groupe photodétecteur (414a) et un second groupe photodétecteur (414b, 414c), la densité des éléments photodétecteurs (410a) inclus dans le premier groupe photodétecteur (414a) étant supérieure à la densité des éléments photodétecteurs (410b, 410c) inclus dans le second groupe photodétecteur (414b, 414c).

4. Dispositif de détection (100) selon la revendication 3, dans lequel l'intensité de la lumière à travers le premier groupe photodétecteur (414a) est supérieure à l'intensité de la lumière à travers le second groupe photodétecteur (414a, 414b).

5. Dispositif de détection (100) selon la revendication 3 ou la revendication 4, dans lequel le premier groupe photodétecteur (414a) est disposé dans une partie centrale de la matrice de photodétecteurs et le second groupe photodétecteur (414b, 414c) est disposé dans une partie externe de la matrice de photodétecteurs entourant la partie centrale ou adjacente à la partie centrale.

6. Dispositif de détection (100) selon l'une quelconque des revendications précédentes, dans lequel les éléments photodétecteurs (210, 410a, 410b, 410c, 610a, 610b, 610c) sont agencés sur une surface plane (630).

7. Dispositif de détection (100) selon l'une quelconque des revendications précédentes, comprenant un dispositif optique (640) configuré pour aplatir un front d'onde de la lumière.

8. Dispositif de détection (100) selon l'une quelconque des revendications 1 à 5, dans lequel les éléments photodétecteurs (510a, 510b, 510c) sont agencés sur une surface incurvée (530).

9. Dispositif de détection (100) selon l'une quelconque des revendications précédentes, dans lequel les groupes photodétecteurs (714) sont agencés pour détecter différentes composantes spectrales de la lumière.

10. Dispositif de détection (100) selon l'une quelconque des revendications précédentes, dans lequel le distributeur optique (108) est configuré pour distribuer la lumière de sorte qu'une variation de la distribution d'intensité de la lumière à travers le groupe photodétecteur (214, 414a, 414b, 414c) soit inférieure à un seuil de tolérance prédéterminé.

11. Dispositif de détection (100) selon la revendication 10, dans lequel le distributeur optique (108) est configuré pour être commuté entre un premier mode dans lequel la lumière est répartie sur le groupe photodétecteur (214, 414a, 414b, 414c) et un second mode dans lequel la lumière n'est pas répartie sur le groupe photodétecteur (214, 414a, 414b, 414c).

12. Dispositif de détection (100) selon l'une quelconque des revendications précédentes, dans lequel chaque élément photodétecteur est configuré pour émettre individuellement le signal de détecteur respectif.

13. Procédé de détection de lumière en utilisant le dispositif de détection (100) selon l'une des revendications précédentes.
